# EUROPÄISCHE PATENTSCHRIFT

(11) **EP 1 686 684 B1**
(45) Veröffentlichungstag und Bekanntmachung des Hinweises auf die Patenterteilung: **31.10.2007**
(21) Anmeldenummer: 06000344.9
(22) Anmeldetag: 10.01.2006
(51) Int. Cl.: H03B 11/02, H01T 9/00

(54) **Mikrowellengenerator**
Microwave generator
Générateur de micro-ondes

(30) Priorität: 18.01.2005 DE 102005002279
(43) Veröffentlichungstag der Anmeldung: 02.08.2006
(73) Patentinhaber: Diehl BGT Defence GmbH & Co.KG, 88662 Überlingen (DE)
(72) Erfinder: Staines, Geoffrey, Dr., 90552 Röthenbach (DE)
(74) Vertreter: Diehl Patentabteilung

(56) Entgegenhaltungen:
- DE-C- 276 624

## Beschreibung

Die Erfindung betrifft einen Mikrowellengenerator mit zwei in einem Gehäuse vorgesehenen, über eine bei Anliegen einer Hochspannung zur Abstrahlung von Mikrowellen durchschlagende Funkenstrecke getrennte Elektroden.

Die Funktion eines solchen Mikrowellengenerators beruht darauf, dass eine Hochspannungsquelle, etwa eine gemäß dem Prinzip der Marx'schen Stoßspannungsschaltung parallel aufgeladene und dann in Serie geschaltene Kondensatorbatterie, über eine Funkenstrecke kurzgeschlossen und damit entladen wird. Infolge des Kurzschlusses entstehen stark oszillierende Entlade-oder Kurzschlussströme mit steiler Flanke, die eine Mischung sehr hoher Frequenzen enthalten, die in der Regel über eine Antenne als Mikrowellenenergie mit einem breitbandigen, vom Frequenzgemisch abhängigen Spektrum abgestrahlt werden. Dieses breitbandige Mikrowellenspektrum weist eine so hohe Energiedichte auf, dass in der Umgebung eines solchen Mikrowellengenerators der Funkverkehr zumindest beeinträchtigt und Eingangskreise elektronischer Schaltungen aufgrund von Resonanzeffekten gestört oder sogar zerstört werden können. Alternativ zur Verwendung einer Marx'schen Stoßspannungsschaltung kann auch ein explosionsstoffgetriebener Hochspannungsgenerator eingesetzt werden, der im Vergleich mit herkömmlichen Hochspannungsgeneratoren einen einzelnen Hochspannungspuls mit extrem hoher Pulsenergie zur Verfügung stellen kann.

Die Abstrahlung der Mikrowellen beruht auf einem entladungsbedingten Resonanzeffekt. Den Zündelektroden, zwischen denen die Funkenstrecke ausgebildet ist, sind weitere resonierende Elektroden- oder Leiterstrukturen zugeordnet, in denen der beim Durchschlagen erzeugte Entladestromimpuls zu kräftigen Sprungoszillationen führt, deren Frequenzgemisch eine Resonanzüberhöhung nach Maßgabe der momentanen elektrisch wirksamen Geometrie des Resonators bzw. der Resonatorstruktur ist.

Ein Mikrowellengenerator der eingangs genannten Art ist aus DE 101 51 565 A1 bekannt. Er besteht aus einer Funkenstrecke, die zwischen einer kleinen, pilzkappenförmigen Elektrode und einer größeren, keulenartigen Elektrode gebildet ist. Ferner ist ein äußerer Leiter vorgesehen, der die keulenförmige Elektrode umgibt, und der über eine entsprechende Verbindungsstruktur mit der pilzkappenförmigen Elektrode verbunden ist. Diese Verbindungsstruktur kann zusammen mit der pilzkappenförmigen Elektrode über einen Spindelmechanismus in ihrer axialen Position bezüglich der feststehenden zweiten Elektrode und des feststehenden, diese umgreifenden Leiters zum Zwecke der Abstimmung verschoben werden. Das Gehäuse dieses Generators ist in dem Bereich, in dem die Elektrodenspindel ausgeführt ist, über einen großflächigen stopfenartigen Isolier-Abschlussdeckel geschlossen, an dem auch der hohlzylindrische Leiter, der sich von diesem Gehäuseende bis zur Resonatorelektrode, diese seitlich beabstandet umgreifend, erstreckt, angeordnet ist.

Diese Generatorausführung ist sehr aufwändig und bedarf einer Vielzahl separater Bauteile, insbesondere im Bereich des Gehäuseabschlusses zur Hochspannungsversorgung, die an die Elektrodenspindel angelegt wird, wo ein speziell hergerichteter Abschlussdeckel aus einem hinreichend ausgelegten Isolierwerkstoff vorgesehen werden muss, an dem zusätzlich zur Führungsspindel auch wie beschrieben der hohlzylindrische Leiter zu lagern ist.

Der Erfindung liegt damit das Problem zugrunde, einen Mikrowellengenerator anzugeben, der einfacher konzipiert ist und zu dessen Herstellung weniger Teile vonnöten sind.

Zur Lösung dieses Problems ist bei einem Mikrowellengenerator der eingangs genannten Art erfindungsgemäß vorgesehen, dass die eine Elektrode topfartig ausgebildet ist und die andere innere Elektrode zumindest über einen Teil ihrer Länge beabstandet außenseitig übergreift, wobei die topfartige Elektrode einen Bodenabschnitt aufweist, der gleichzeitig den seitlichen Abschluss des Gehäuses bildet.

Bei dem erfindungsgemäßen Mikrowellengenerator ist die eine Zündelektrode selbst als größerflächige Leiterstruktur ausgebildet, die im Wesentlichen topfartig ausgeführt ist. Sie weist einen Bodenabschnitt auf, über den die Hochspannungszufuhr erfolgt. Aufwändige Kontaktierungen wie im Falle der axialen Hochspannungskontaktierungen in DE 101 51 565 A1 entfallen vorteilhaft.

Von dem geschlossenen Bodenabschnitt dieser metallischen Elektrode, die zur Bildung der Funkenstrecke eine geeignete Nase oder dergleichen, die der inneren Elektrode beabstandet gegenübersteht, aufweist, geht randseitig ein sich axial erstreckender Abschnitt ab, der die innere, bevorzugt keulenartige Elektrode beabstandet umgreift. Dieser Abschnitt kann geschlossen ausgeführt sein, das heißt, die topfartige Elektrode bildet ein rotationssymmetrisches, hohlzylindrisches Bauteil, alternativ kann dieser Abschnitt auch unter Verwendung mehrerer parallel laufender Stäbe oder Abschnitte, die eine Art Käfig bilden, realisiert sein.

Unter Verwendung einer derart ausgeführten Elektrode kann auf einfache Weise ein Mikrowellengenerator realisiert werden. Denn die Elektrode als einstückiges, einzelnes Bauteil erfüllt mehrere Funktionen. Zum einen die der Ausbildung der Funkenstrecke, zum anderen bietet sie die Möglichkeit der Hochspannungszuführung, und schließlich bildet sie mit ihrem Bodenabschnitt gleichzeitig die Abschlussplatte des Gehäuses, so dass in diesem Bereich keine separaten Isolierplatten oder dergleichen mehr vorzusehen sind. Der gesamte Aufbau des Generators wird hierdurch vereinfacht.

In Weiterbildung der Erfindung kann vorgesehen sein, dass die Innenform der topfartigen Elektrode zumindest über einen Teil der Länge, über die sie die innere Elektrode übergreift, im Wesentlichen der Außenform der inneren Elektrode entspricht. Das heißt, die Form der einander gegenüberliegenden Flächen der inneren und der äußeren Elektrode bzw. des Elektrodenabschnitts sind aufeinander abgestimmt, um die sich ergebende Koaxialleiterstruktur im Hinblick auf die hohen Ladespannungen zu optimieren. Dabei kann der Abstand zwischen innerer und äußerer Elektrode zumindest über einen Teil der Länge, über die sie einander radial übergreifen, näherungsweise gleich sein. Insbesondere sollte das Verhältnis des Innendurchmessers der äußeren Elektrode zum Außendurchmesser der inneren Elektrode zumindest über einen Teil der Länge, über die sie einander radial übergreifen, näherungsweise konstant sein. Hierüber wird erreicht, dass die Impedanz der Elektroden- bzw. Leiterstruktur im radialen Übergriffsbereich annähernd überall gleich ist und es zu keinen Impedanzsprüngen, an denen es zu Reflexionen der im Entladefall oszillierenden Entlade- oder Kurzschlussströme kommt, in diesem Bereich vorhanden sind.

Wie beschrieben sind aus insbesondere fertigungstechnischen Gründen beide Elektroden rotationssymmetrisch, wobei die innere Elektrode bevorzugt keulenartig und die äußere Elektrode bevorzugt hohlzylindrisch ausgebildet ist.

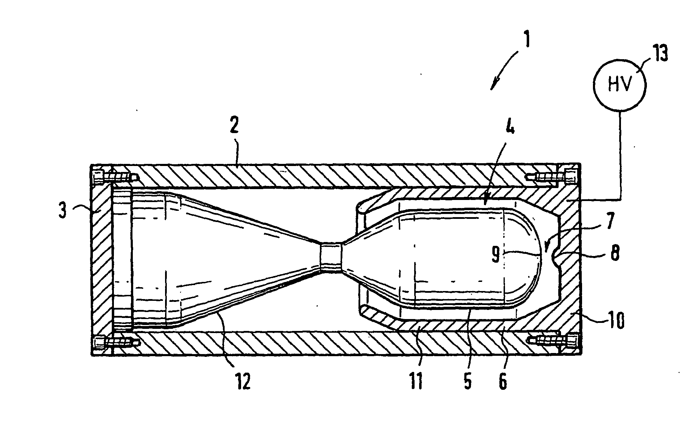

Weitere Vorteile, Merkmale und Einzelheiten der Erfindung ergeben sich aus dem im folgenden beschriebenen Ausführungsbeispiel sowie anhand der Zeichnung.

Die Figur zeigt einen erfindungsgemäßen Mikrowellengenerator 1 in Form einer Prinzipdarstellung. Er besteht aus einem zylindrischen Isoliergehäuse 2, bevorzugt einem Glasfasergehäuse, das an einer Seite über einen Abschlussdeckel 3, beispielsweise aus einem Isoliermaterial, geschlossen ist. Im Inneren ist ein Resonator 4 ausgebildet, bestehend aus zwei einander gegenüberliegenden Elektroden 5, 6, wobei die Elektrode 5 im Wesentlichen keulenförmig mit einem mittleren zylindrischen Abschnitt konstanten Durchmessers ausgebildet ist und die innere Elektrode bildet, während die Elektrode 6 topfartig ausgeführt ist und die äußere Elektrode bildet. Beide sind rotationssymmetrische Bauteile.

Die beiden Bauteile 5, 6 sind über eine Funkenstrecke 7 voneinander getrennt, welche Funkenstrecke 7 über zwei Zündelektroden 8, 9 ausgebildet ist. Die Zündelektrode 8 ist als vorspringende Nase an der äußeren Elektrode 6 ausgebildet, während die Zündelektrode 9 als integrale Fläche an der Kugelkappe der inneren Elektrode 5 realisiert ist.

Im Inneren des Gehäuses ist mit hohem Druck ein bevorzugt gasförmiges Dielektrikum, vornehmlich SF₆ mit hohem Druck aufgenommen.

Wie die Figur zeigt, weist die äußere Elektrode 6 eine topfartige Form auf. Sie besteht aus einem Bodenabschnitt 10, an dem axial vorspringend ein hohlzylindrischer Elektrodenabschnitt 11 vorgesehen ist, der wie die Figur zeigt den keulenartigen Resonator bzw. die Elektrode 5, an der eine Antenne 12 als abstrahlendes Element in Form einer trichterartigen Struktur angeordnet ist, umgreift. Der Elektrodenabschnitt 11 weist im mittleren Bereich, wo er den zylindrischen mittleren Abschnitt der Elektrode 5 umgreift, ebenfalls einen konstanten Innendurchmesser auf.

Ersichtlich bildet der Bodenabschnitt 10 der Elektrode 6 gleichzeitig die seitliche Abschlussplatte des Gehäuses 2, über die der Gehäuseinnenraum, der wie beschrieben mit dem gasförmigen Dielektrikum (alternativ kann auch ein flüssiges Dielektrikum wie beispielsweise Öl verwendet werden) gefüllt ist, dicht abgeschlossen ist. Der einstückigen, bevorzugt als metallenes Drehteil ausgeführten Elektrode 6 kommt damit über ihre eigentliche Elektrodenfunktion eine weitere Funktion zu.

Wie die Figur zeigt, ist die Innenform der Elektrode 6, insbesondere in dem mittleren zylindrischen Bereich des Elektrodenabschnitts 11, der radial beabstandet zum mittleren zylindrischen Bereich der inneren Elektrode 5 liegt, entsprechend der Außenkontur der inneren Elektrode ausgeführt. Bevorzugt ist der Abstand zwischen dem Elektrodenabschnitt 11 und der inneren Elektrode, zumindest in diesem Bereich, in dem sie beide einander achsparallel gegenüberliegen, konstant. Generell sollte in den Längenabschnitten, in denen die beiden Elektroden einander umgreifen - abgesehen von dem Bereich, in dem der Bodenabschnitt 10 der Kugelkappe gegenüberliegt und dem gegenüberliegenden Bereich, wo sich beide Elektroden 5, 6 im Durchmesser vergüngen - das Verhältnis des Innendurchmessers des mittleren Bereichs des Elektrodenabschnitts 11 zum Außendurchmesser des mittleren Bereichs der inneren Elektrode 5 im Wesentlichen konstant sein, um über die Länge der einander gegenüberliegenden Abschnitte auch ein konstantes Impedanzverhalten zu realisieren. Wie die Figur zeigt, verjüngt sich die Elektrode 5 im Übergangsbereich zur Antenne 12, das heißt der Durchmesser nimmt ab. Entsprechend nimmt auch der Durchmesser der äußeren Elektrode 6 im Endbereich ab, jedoch nicht so stark, wie sich der Durchmesser der inneren Elektrode 5 reduziert. Diese ungleichmäßige Durchmesseränderung ermöglicht eine gezielte Impedanzanpassung. Hier wird ein gezielter Impedanzsprung realisiert, an dem ein Teil des schwingenden Stroms reflektiert wird. Über die konkrete, geometriebedingte Impedanzform bzw. den Impedanzverlauf kann die Form und die Dauer der abgestrahlten Mikrowellenpulse entsprechend angepasst werden.

Wie beschrieben bildet der Bodenabschnitt 10 gleichzeitig den Gehäuseabschluss. Dies ermöglicht eine einfache Kontaktierung mit der Hochspannungsquelle 13, beispielsweise einem Marx'schen Stossspannungsgenerator. Die Verwendung einer einstückigen, metallenen Elektrode der beschriebenen Form bietet ferner die Möglichkeit, die mit der Verwendung separater Isolatorelemente im Bereich der Hochspannungszufuhr verbundenen Probleme zu vermeiden. Diese Isolatoren halten häufig der extremen Beanspruchung, wie sie die extrem hohen Feldstärken, die im Durchschlagfall auf den Isolator wirken, typischerweise in der Größenordnung von 100 - 500 GV/m, nicht stand, so dass es zu Fehlfunktionen im Isolatorbereich kommt, oder aber eine entsprechende Dimensionierung der Isolatorelemente erforderlich ist. Die Erkenntnis, dass in diesem Bereich überhaupt kein Isolator zu verwenden ist lässt es vorteilhaft zu, neben einem einfachen Aufbau auch die aus der Verwendung von Isolatormaterial resultierenden Probleme zu beseitigen.

Im Betrieb wird an den Bodenabschnitt 10 und damit die Elektrode 6 der Hochspannung angelegt, das heißt, die sich aus den Elektroden 5, 6 ergebende Kondensatorstruktur wird aufgeladen. Bei Erreichen der Durchbruchspannung zündet die Funkenstrecke 7, so dass es zu den bereits eingangs beschriebenen Entlade- oder Kurzschlussströmen kommt, die oszillierende Schwingungen auf der Elektrode 5 durchführen.

## Patentansprüche

1. Mikrowellengenerator mit zwei in einem Gehäuse vorgesehenen über eine bei Anliegen einer Hochspannung zur Abstrahlung von Mikrowellen durchschlagende Funkenstrecke getrennten Elektroden,
**dadurch gekennzeichnet,**
**dass** die eine Elektrode (6) topfartig ausgebildet ist und die andere innere Elektrode (5) zumindest über einen Teil ihrer Länge außenseitig beabstandet übergreift, wobei die topfartige Elektrode (6) einen Bodenabschnitt (10) aufweist, der gleichzeitig einen seitlichen Abschluss des Gehäuses bildet.

2. Mikrowellengenerator nach Anspruch 1,
**dadurch gekennzeichnet,**
**dass** die Innenform der topfartigen Elektrode (6) zumindest über einen Teil der Länge, über die sie die innere Elektrode (5) übergreift, im Wesentlichen der Außenform der inneren Elektrode (5) entspricht.

3. Mikrowellengenerator nach Anspruch 1 oder 2,
**dadurch gekennzeichnet,**
**dass** der Abstand zwischen innerer und äußerer Elektrode (5, 6) zumindest über einen Teil der Länge, über die sie einander radial übergreifen, näherungsweise gleich ist.

4. Mikrowellengenerator nach einem der vorangehenden Ansprüche,
**dadurch gekennzeichnet,**
**dass** das Verhältnis des Innendurchmessers der äußeren Elektrode (6) zum Außendurchmesser der inneren Elektrode (5) zumindest über einen Teil der Länge, über die sie einander radial übergreifen, näherungsweise konstant ist.

5. Mikrowellengenerator nach einem der vorangehenden Ansprüche,
**dadurch gekennzeichnet,**
**dass** beide Elektroden (5, 6) rotationssymmetrisch sind, wobei die innere Elektrode (6) keulenartig und die äußere Elektrode (5) hohlzylindrisch ausgebildet ist.

## Claims

1. Microwave generator having two electrodes which are provided in a housing and are separated by a spark gap which flashes over when a high voltage is applied in order to emit microwaves, **characterized in that** one electrode (6) is in the form of a pot and clasps the other inner electrode (5) over at least a part of its length on the outside and at a distance from it, with the pot-like electrode (6) having a base section (10) which at the same time forms a side termination of the housing.

2. Microwave generator according to Claim 1, **characterized in that** the internal shape of the pot-like electrode (6) corresponds essentially to the external shape of the inner electrode (5), at least over a part of the length over which it clasps the inner electrode (5).

3. Microwave generator according to Claim 1 or 2, **characterized in that** the distance between the inner and the outer electrode (5, 6) is approximateley the same, at least over a part of the length over which they radially clasp one another.

4. Microwave generator according to one of the preceding claims, **characterized in that** the ratio of the internal diameter of the outer electrode (6) to the external diameter of the inner electrode (5) is approximately constant, at least over a part of the length over which they radially clasp one another.

5. Microwave generator according to one of the preceding claims, **characterized in that** the two electrodes (5, 6) are rotationally symmetrical, with the inner electrode (6) being in the form of a lobe, and the outer electrode (5) being hollow-cylindrical.

## Revendications

1. Générateur de micro-ondes comprenant deux électrodes prévues dans un boîtier et séparées par une distance de décharge qui est transpercée lors de l'application d'une haute tension pour émettre des micro-ondes, **caractérisé en ce qu'**une électrode (6) est réalisée en forme de creuset et l'autre électrode (5) intérieure la recouvre au moins sur une partie de sa longueur avec un écart côté extérieur, l'électrode en forme de creuset (6) présentant une portion de fond (10) qui forme simultanément un raccord latéral du boîtier.

2. Générateur de micro-ondes selon la revendication 1, **caractérisé en ce que** la forme intérieure de l'électrode en forme de creuset (6) correspond pour l'essentiel à la forme extérieure de l'électrode intérieure (5) au moins sur une partie de la longueur sur laquelle elle recouvre l'électrode intérieure (5).

3. Générateur de micro-ondes selon la revendication 1 ou 2, **caractérisé en ce que** l'écart entre l'électrode intérieure et l'électrode extérieure (5, 6) est approximativement constant au moins sur une partie de la longueur sur laquelle elles se chevauchent l'une l'autre dans le sens radial.

4. Générateur de micro-ondes selon l'une des revendications précédentes, **caractérisé en ce que** le rapport entre le diamètre intérieur de l'électrode extérieure (6) et le diamètre extérieur de l'électrode intérieure (5) est approximativement constant au moins sur une partie de la longueur sur laquelle elles se chevauchent l'une l'autre dans le sens radial.

5. Générateur de micro-ondes selon l'une des revendications précédentes, **caractérisé en ce que** les deux électrodes (5, 6) sont à symétrie rotationnelle, l'électrode intérieure (6) étant réalisée en forme de lobe et l'électrode extérieure (5) étant cylindrique et creuse.
